# FASCICULE DE BREVET EUROPEEN

(11) **EP 0 875 899 B1**
(45) Date de publication et mention de la délivrance du brevet: **18.06.2003**
(21) Numéro de dépôt: 98400661.9
(22) Date de dépôt: 20.03.1998
(51) Int. Cl.: G11C 7/00, G11C 8/00

(54) **Ensemble de deux mémoires sur un même circuit intégré monolithique**
Anordnung von zwei Speichern auf der selben monolitischen integrierten Schaltung
Arrangement of two memories on the same monolithic integrated circuit

(30) Priorité: 08.04.1997 FR 9704285
(43) Date de publication de la demande: 04.11.1998
(73) Titulaire: STMicroelectronics S.A., 92120 Montrouge (FR)
(72) Inventeur: Brigati, Alessandro, 75116 Paris (FR); Devin, Jean, 75116 Paris (FR); Leconte, Bruno, 75116 Paris (FR)
(74) Mandataire: Ballot, Paul

(56) Documents cités:
- EP-A- 0 411 633
- EP-A- 0 481 437
- US-A- 5 349 578
- US-A- 5 615 355

## Description

L'invention concerne un circuit intégré monolithique comportant deux mémoires, de préférence distinctes l'une de l'autre, et des circuits électroniques pour permettre le fonctionnement en simultané des deux mémoires.

Elle s'applique tout particulièrement aux mémoires non volatiles, programmables et effaçables électriquement EEPROM, flash EPROM ou encore mémoires sauvegardées par pile. Chacune des cellules mémoires de ces deux premières mémoires est constituée d'un transistor à grille flottante comportant une grille de commande, une grille flottante, une région source et une région drain. Pour écrire ou lire une telle cellule mémoire, on applique des tensions spécifiques sur des connexions qui mènent à ces cellules. Ces tensions dépendent des types de mémoire.

Par exemple pour programmer une cellule mémoire dans une mémoire EEPROM, on applique à la ligne de mots, reliée à la grille de commande du transistor à grille flottante de la cellule mémoire, une tension fortement positive et à la ligne de bit reliée à la région drain une tension nulle. L'application de ces tensions crée à travers l'étroite couche d'oxyde une forte tension ayant pour résultat la migration d'électrons vers la grille flottante. Ces électrons sont piégés dans la grille flottante. Le phénomène mis en jeu est un phénomène tunnel.

Dans un autre exemple, pour programmer une mémoire de type flash EEPROM, les tensions appliquées aux divers électrodes d'une cellule mémoire sont différentes. Lors d'une programmation, on applique une forte tension positive à la ligne de mots du transistor d'une cellule mémoire. On applique une tension intermédiaire, par exemple positive de l'ordre de 5V, à la région drain. Tout comme dans une mémoire de type EEPROM, l'application de ces tension provoquent une migration des électrons. Le phénomène mis en jeu est un phénomène dit de porteurs chauds.

Il existe donc une certaine disparité entre les tensions de programmation et de lecture, à la fois pour une même mémoire et à la fois pour des mémoires de types différents.

Sur un circuit intégré monolithique, intégrant notamment des mémoires de différents types, on veut toutefois conserver la possibilité d'un fonctionnement simultané comme si les deux mémoires ne se trouvaient pas sur le même circuit intégré. On veut par ailleurs utiliser des mémoires de types différents sur un même circuit intégré car les types différents conduisent à des caractéristiques différentes: vitesse plus ou moins grande d'écriture, densité d'intégration, accessibilité bit par bit ou page par page. Un concepteur peut alors, avec un même circuit intégré, disposer de facultés différentes qui lui permettent de mieux s'organiser.

Il est connu dans l'état de la technique de disposer d'un même circuit intégré comportant deux mémoires distinctes l'une de l'autre. Cependant la possibilité d'effectuer des opérations simultanées sur ces deux mémoires est limitée. On sait ainsi lire ou écrire dans une mémoire de type flash EPROM, tout en lisant ou en écrivant dans une mémoire de type EEPROM, à condition de dupliquer toutes les fonctions utiles. Ceci signifie doublement des bus et des circuits auxquels ils sont reliés. L'état de la technique n'offre aucune alternative. Le problème présenté est que ces fonctions occupent alors beaucoup de place sur le circuit intégré et en réduisent l'efficacité. Notamment le fait d'avoir deux bus est rédhibitoire. Si on n'a qu'un bus, le fonctionnement des mémoires n'est pas simultané, il est alternatif. Dans ce cas il y a une perte de temps.

L'invention a pour objet de remédier à ce problème en permettant l'écriture ou la lecture dans une mémoire en même temps qu'on permet l'écriture ou la lecture dans l'autre mémoire, ces deux mémoires étant présentes sur le même circuit intégré. De préférence, il n'y a qu'un bus.

En pratique, l'invention propose de remédier à ce problème en permettant de sélectionner l'une ou l'autre des mémoires et d'y effectuer des opérations d'écriture ou de lecture pendant que l'autre mémoire est en lecture ou en écriture. Dans l'invention on tire parti du fait qu'une opération de programmation ou de lecture dure un certain temps prédéterminé, durée qui est spécifique à chaque mémoire. Plutôt que d'en être gêné, on utilise le temps d'occupation d'une mémoire à l'une de ces tâches pour l'isoler, sélectionner l'autre mémoire, et commencer à faire exécuter à cette autre mémoire une lecture ou une écriture. On utilise donc un signal de sélection pour commencer une tâche. La continuation de la tâche est conditionnée par un signal de maintien déclenché par ce signal de sélection.

Ainsi, l'invention a pour objet un circuit intégré monolithique comportant deux mémoires distinctes l'une de l'autre, un microcontrôleur pour séquencer des opérations d'écriture ou de lecture de ces mémoires, un circuit de sélection propre à sélectionner l'une ou l'autre des mémoires et recevant un signal de sélection. L'invention est caractérisée en ce que le circuit intégré comporte deux microcontrôleurs en relation chacun avec une des mémoires et en ce que chaque microcontrôleur comporte un circuit pour exécuter dans chaque mémoire les opérations d'écriture ou de lecture indépendamment de la valeur du signal de sélection.

Dans un exemple, pour résoudre le problème des tensions spécifiques à appliquer pour un type particulier de mémoire, on a dupliqué des pompes de charge. Ainsi, l'ensemble constitué par le microcontrôleur et les pompes de charge permet d'effectuer des opérations de programmation ou de lecture dans chaque mémoire indépendamment l'une de l'autre.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- figure 1 : la représentation schématique d'un circuit conforme à l'invention;
- figure 2 : des diagrammes temporels de signaux utilisés dans l'invention.

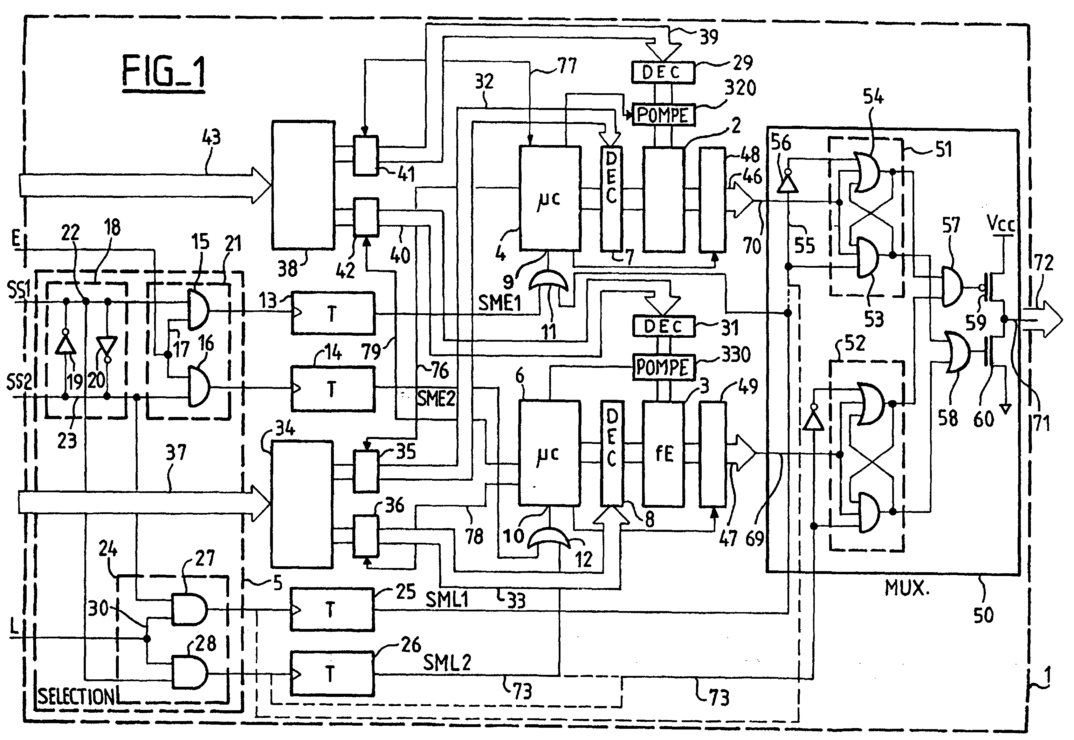

Sur la figure 1, on a représenté un circuit intégré 1 comportant deux mémoires, 2 et 3, distinctes l'une de l'autre. Dans un exemple, en plus d'être distinctes, les deux mémoires sont de type différent: la mémoire 2 est une EEPROM, la mémoire 3 est une flash EPROM. Un microcontrôleur 4 est propre à provoquer l'exécution en séquence des opérations d'écriture et/ou de lecture dans ces mémoires 2 et 3. Un microcontrôleur est un microprocesseur muni d'une mémoire programme dédiée. Un microcontrôleur ne sait en pratique qu'effectuer les actions enregistrées dans la mémoire programme. Un circuit de sélection 5 permet de sélectionner l'une ou l'autre de ces mémoires 2 ou 3. Dans un exemple, un double signal de sélection SS1 et SS2 est appliqué à l'entrée de ce circuit 5. Les signaux SS1 et SS2 sont complémentaires. Selon l'invention, le circuit intégré 1 comporte un deuxième microcontrôleur 6 du même type. Les deux microcontrôleurs 4 et 6 sont en relation chacun avec une des mémoires respectivement 2 et 3.

Un décodeur d'adresse 7 est commandé par le microcontrôleur 4. Le décodeur 7 permet l'accès à la mémoire 2. De même, un décodeur 8 d'adresse est commandé par le microcontrôleur 6. Le décodeur 8 permet l'accès à la mémoire 3.

Selon l'invention, chaque microcontrôleur 4 et 6 comporte un circuit, respectivement 13 ou 14 ou 25 ou 26, pour exécuter dans chaque mémoire les opérations d'écriture ou de lecture, indépendamment de la valeur du signal de sélection SS1 ou SS2. Dans ce but, une entrée de validation 9 et 10 de chaque microcontrôleur respectivement est reliée, dans un exemple, à la sortie d'une porte OU respectivement 11 et 12 à deux entrées. Avec ces deux entrées on veut valider ces microcontrôleurs en écriture ou en lecture.

Une première des entrées de chaque porte OU 11 et 12 est reliée au circuit de sélection 5 par l'intermédiaire des circuits 13 et 14 propres à fournir un signal de temporisation d'écriture de durée T ou T'. Les circuits 13 et 14 sont déclenchés lors d'une sélection en écriture et produisent un signal maintenu SME1 (signal de maintien en écriture) pendant cette durée T ou SME2 pendant une durée T'.

Les circuits 13 et 14 peuvent être par exemple des circuits multivibrateurs monostables. En variante, les circuits 13 et 14 sont partie intégrante, avec les portes OU 11 et 12, des microcontrôleurs 4 et 6. Dans ce cas, les circuits 13 et 14 peuvent être constitués de microprogrammes de comptage effectués par les microcontrôleurs 4 et 6. Ces microprogrammes de comptage comptent par exemple un nombre prédéterminé d'impulsions d'un signal d'horloge produit par ou fourni au microcontrôleur.

La durée T du signal SME1 est choisie de telle sorte qu'elle soit supérieure ou égale à une durée d'exécution d'une écriture dans la mémoire 2. Il peut y avoir par ailleurs deux durées: une durée T longue pour une écriture, une durée T" pour une lecture. On verra plus loin comment s'opère la distinction.

Les entrées des circuits 13 et 14 sont reliées à des sorties de portes ET respectivement 15 et 16 à deux entrées. Les portes 15 et 16 forment un premier circuit logique 21. Une première entrée de la porte 15 est reliée à une première entrée de la porte 16 par une connexion 17. La connexion 17 reçoit une commande d'écriture E commune aux deux mémoires 2 et 3. Le circuit 21 reçoit par ailleurs sur les deuxièmes entrées des portes 15 et 16 les signaux de sélection SS1 et SS2 respectivement. Ces signaux permettent de sélectionner une des mémoires 2 ou 3 en écriture en fonction du niveau logique des deux signaux de sélection SS1 ou SS2 et du niveau du signal E.

Les deuxièmes entrées de ces portes 15 et 16 sont reliées à des connexions qui véhiculent les signaux de sélection respectivement SS1 et SS2 par l'intermédiaire d'un circuit 18 à deux entrées et deux sorties. Le circuit 18 est constitué de deux inverseurs rebouclés 19 et 20 en parallèle sur ses deux entrées et ses deux sorties. Le circuit 18 assure la sélection d'une seule des deux mémoires à la fois. La connexion 22 qui relie la sortie de l'inverseur 19 et l'entrée de l'inverseur 20 constitue à la fois une entrée et une sortie de ce circuit 18 reliée à la porte 15. La connexion 23 qui relie la sortie de l'inverseur 20 et l'entrée de l'inverseur 19 constitue à la fois une deuxième entrée et une deuxième sortie de ce circuit 18 reliées à la porte 16. Les deux entrées du circuit 18 correspondent aux signaux de sélection SS1 et SS2. On ne sélectionne qu'une mémoire à la fois dans la mesure où on ne veut pas dupliquer les mémorisations. Cependant, dans une utilisation en miroir, le circuit 18 peut être omis, les deux mémoires pouvant être sélectionnées en même temps.

Les portes OU 11 et 12 comportent une deuxième entrée. Les deuxièmes entrées de ces portes 11 et 12 sont reliées de même à un circuit temporisateur, par exemple ici aussi un multivibrateur monostable, respectivement 25 et 26. Ces deux circuits 25 et 26 ont les mêmes fonctions que les deux circuits 13 et 14 définis précédemment et sont de la même façon reliés au circuit de sélection 5. Les portes OU 11 et 12 reçoivent les signaux maintenus (SME1 SME2 et SML1 SML2 selon le mode écriture ou lecture retenu) de lecture et d'écriture. Elles délivrent un signal de maintien, pendant l'opération d'écriture ou de lecture retenue, dans le microcontrôleur sélectionné.

Le circuit de sélection 5 comporte ainsi un deuxième circuit logique 24. Ce circuit 24 est de constitution identique au circuit 21. Il comporte deux portes ET 27 et 28 dont les sorties sont reliées aux entrées des circuits respectivement 25 et 26. Le circuit 24 comporte trois entrées. Une première entrée de la porte 27 est reliée à une première entrée de la porte 28 par une connexion 30 et constitue une première entrée du circuit 24. La connexion 30 reçoit une commande de lecture L commune aux deux mémoires 2 et 3. Le circuit 24 reçoit par ailleurs sur les deuxièmes entrées des portes 27 et 28 les signaux de sélection SS1 et SS2 pour permettre de sélectionner une de ces mémoires 2 ou 3. Ces signaux permettent la sélection d'une mémoire exclusivement.

Chacune des mémoires 2 et 3 comporte des circuits décodeurs d'adresse et de données respectivement 7 et 29 et 8 et 31. Conformément à l'invention, les décodeurs d'adresse sont dupliqués pour permettre un décodage d'adresses pour chacune des mémoires 2 et 3, indépendamment l'une de l'autre. Le décodeur 7 d'adresse est relié au microcontrôleur 4 et aux lignes de mots de la mémoire 2. Le décodeur 8 est relié au microcontrôleur 6 et aux lignes de mots de la mémoire 3. Ces décodeurs 7 et 8 reçoivent les adresses à décoder par des bus d'adresse respectivement 32 et 33 dont le nombre de lignes est caractéristique des mémoires 2 et 3. Les bus 32 et 33 sont tous deux issus d'un même circuit de démultiplexage 34 d'adresses. Le circuit 34 reçoit à son entrée un bus 37 d'adresse, commun aux deux mémoires 2 et 3. Le bus 37 est connecté aux broches (non représentées) du circuit intégré 1. Des mémoires tampons respectivement 35 et 36, contrôlées par les microcontrôleurs respectivement 4 et 6 permettent de mémoriser les bits des adresses transmises par le démultiplexeur 34.

Les deux mémoires 2 et 3 sont reliées à un autre décodeur de données respectivement 29 et 31. Les décodeurs 29 et 31 reçoivent des signaux de donnée à appliquer sur les lignes de bit des mémoires 2 et 3. Des pompes de charge 320 et 330 sont reliées, respectivement, aux sorties du décodeur 29 et à la mémoire 2, et aux sorties du décodeur 31 et à la mémoire 3. Les pompes de charge sont contrôlées par le microcontrôleur qui leur correspond. Ces pompes permettent de polariser les lignes de chacune des mémoires indépendamment l'une de l'autre. En effet, la présence de ces pompes permet de polariser les lignes de chacune des mémoires 2 et 3 à des potentiels différents et donc de lire ou d'écrire simultanément dans chacune des mémoires.

Chaque décodeur 29 et 31 est relié à un bus 39 et 40 de données respectivement issu d'un circuit de démultiplexage 38 de données. Afin de mémoriser les données à programmer, des mémoires tampons 41 et 42 sont installés sur ces bus respectivement 39 et 40 en sortie du démultiplexeur 38. Ces mémoires tampons 41 et 42 sont contrôlées par les microcontrôleurs respectivement 4 et 6. Le démultiplexeur 38 est relié à son entrée à un bus 43 de données commun aux deux mémoires. Le bus 43 est raccordé à l'extérieur du circuit 1.

Chaque mémoire 2 ou 3 peut comporter un bus respectivement 46 et 47 de sortie de données. Ces bus 46 et 47 sont reliés aux mémoires 2 et 3 par des circuits de lecture respectivement 48 et 49 contrôlés par les microcontrôleurs 4 et 6. En variante, les circuits 48, 29 et 320 sont reliés à un même bus d'entrée sortie 39-46. De même, en variante, les circuits 49, 31 et 330 sont liés à un même bus d'entrée sortie de donnée 40-47. Dans ce cas les circuits 48 et 29, et 49 et 31 sont réalisés sous la forme d'un seul circuit à chaque fois. Dans ce cas également, le démultiplexeur 38 peut servir de multiplexeur pour délivrer des données en sortie sur le bus 43.

On va expliquer maintenant le fonctionnement d'un tel multiplexeur. Les circuits 48 et 49 délivrent en sortie des données dont le nombre de bits dépend du nombre de lignes des bus 39 ou 40. Dans un exemple, il y a à chaque fois huit lignes de bit et on forme des mots de huit bits. Chacun des bits lus dans un mot dans une mémoire est appliqué à l'entrée d'un élément multiplexeur 50 à deux entrées. L'autre entrée de cet élément multiplexeur 50 est dédiée à un bit lu dans un mot dans l'autre mémoire. Il y a de préférence correspondance entre la longueur de mots lus ou écrits dans une mémoire et ceux lus ou écrits dans une autre. Ceci n'est cependant pas une obligation. Il y a autant d'éléments multiplexeurs 50 que le mot le plus long à lire dans une mémoire comporte de bits.

L'élément multiplexeur 50 comporte en entrée deux bascules identiques 51 et 52. Les entrées des bascules 51 et 52 sont reliées à un des fils des bus 46 et 47 respectivement. Chaque bascule 51 et 52 est constituée de deux portes identiques. Par exemple, la bascule 51 comporte une porte ET 53 à trois entrées et une porte OU 54 à trois entrées. Une première entrée de la porte ET 53 est reliée par une connexion 55 et par un inverseur 56 à une entrée de la porte OU 54. La connexion 55 est par ailleurs reliée à la sortie du circuit 25. Une deuxième entrée de la porte 53 est reliée à la sortie de la porte 54. Inversement la sortie de la porte 53 est reliée à une deuxième entrée de la porte 54. Les troisièmes entrées des portes 53 et 54 sont reliées ensemble à un fil 70 du bus 46. La deuxième bascule 52 comprise dans l'élément multiplexeur 50 est identique à la bascule 51 mis à part que les signaux qui la commandent sont issus de l'autre circuit temporisateur 26 par une connexion 73. D'autre part une connexion 69 équivalente à la connexion 70 de la première bascule est reliée à la sortie du circuit de lecture 49.

Les deux bascules 51 et 52 ont chacune deux sorties. Les sorties des portes OU (54) des deux bascules 51 et 52 sont connectées aux deux entrées d'une porte ET 57 à deux entrées. Les sorties des portes ET (53) des deux bascules 51 et 52 sont connectées aux deux entrées d'une porte OU 58 à deux entrées. Ces deux portes 57 et 58 ont leur sorties appliquées à des grilles de commande respectivement d'un transistor MOS de type P 59 et d'un transistor MOS de type N 60. Ces deux transistors sont en série. La source du transistor 59 est reliée au potentiel Vcc, alimentation du circuit intégré. Le drain du transistor 60 est relié à la masse. La sortie de l'élément multiplexeur 50 se situe au point milieu des deux transistors 59 et 60 disposés en série.

Le point milieu des transistors 59 et 60 est relié à une connexion 71. Il y a autant de connexions 71 qu'il y a d'éléments multiplexeur 50. Les connexions 71 ensemble forment le bus 72 de sortie de données du circuit intégré 1.

L'élément multiplexeur 50 est connecté par la connexion 55 en sortie du circuit 25. De cette façon il est commandé par le signal de sélection de lecture L après la transformation de ce signal L en signal SML1, maintenu, par le circuit 25. Le signal SML1 permet de fournir en sortie la donnée issue de la mémoire sélectionnée.

Dans un autre exemple, le multiplexeur 50 peut être commandé directement par le signal de lecture. Cette solution est montrée en tirets sur la figure 1. Dans ce cas les signaux de sélection doivent être imposés de l'extérieur du circuit 1 à la fois au moment de la sélection en lecture et au moment de la sortie des données sur le bus 72.

Le signal présent sur la connexion 55 permet selon les cas d'inhiber la bascule 51 ou au contraire de la rendre passante.

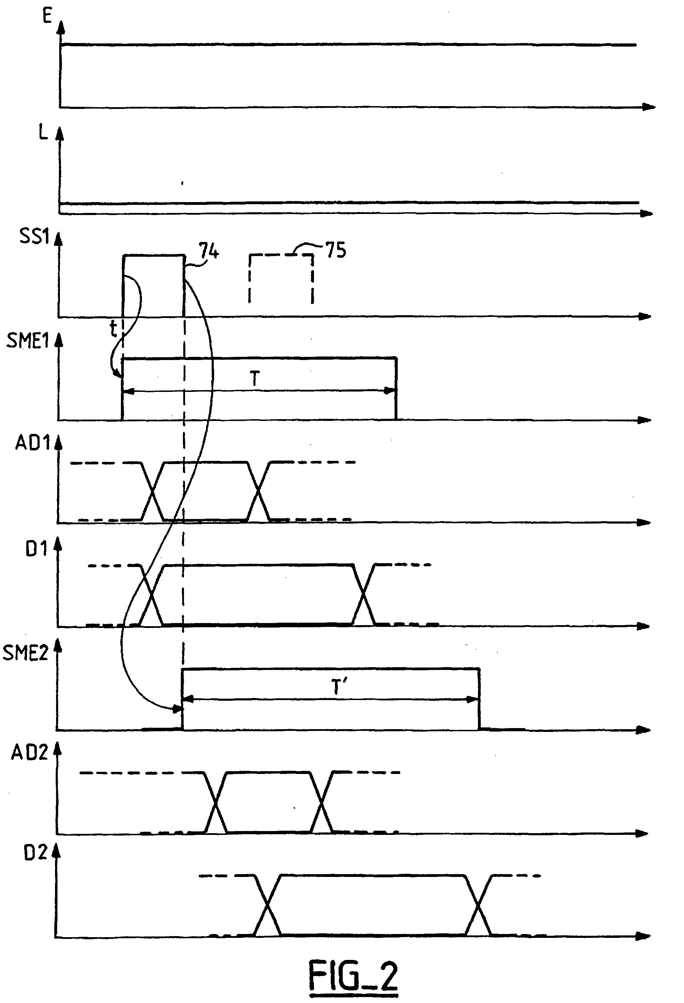

On décrit maintenant en référence à la figure 2 un mode d'utilisation du circuit de la figure 1. Ce mode permet de mettre en évidence le fonctionnement des deux microcontrôleurs 2 et 3 exécutant dans chaque mémoire d'une manière autonome des opérations d'écriture.

On considère ici que le signal de commande d'écriture E est actif. Le haut de la figure 1 montre que le signal E est actif (au niveau 1) alors que le signal L est inactif. Cette complémentarité, habituelle, n'est cependant pas nécessaire. Dans le cas de la sélection de la mémoire 2, on applique à l'entrée du circuit de sélection 5, par exemple à la date t, un signal de sélection SS1 actif (niveau 1). Le circuit 18 place automatiquement le signal SS2 de sélection de la mémoire 3 à un niveau logique complémentaire (inactif). Le signal de sélection SS1 déclenche un signal SME1 de temporisation, de durée T, par l'intermédiaire du circuit 13. Celui-ci produit un signal maintenu SME1 caractéristique d'une sélection en écriture de la mémoire 2. La durée T de ce signal SME1 est supérieure ou égale à la durée d'exécution d'une écriture. Le microcontrôleur 4 est donc validé par ce signal de durée T appliqué sur la porte 11. Il est en même temps isolé de l'extérieur, insensible à une retombée 74 du signal SS1 ou même à un éventuel signal intempestif 75.

Le signal de maintien produit à la sortie de la porte 11 donne l'ordre au microcontrôleur d'exécuter dans la mémoire 2 l'opération d'écriture. Les adresses AD1 envoyées sur le bus 37 consécutivement à l'ordre d'écriture E, ou de sélection SS1, sont présentes à la sortie du démultiplexeur d'adresse 34. Le démultiplexeur 34 oriente correctement les adresses qu'il reçoit, soit parce qu'il reçoit un ordre dans ce sens du microcontrôleur 4, soit parce qu'il discrimine en fonction de l'adresse lue sur le bus 37 celle des mémoires tampons 35 ou 36 qui doit être sollicitée. En variante, les deux mémoires tampons 35 et 36 présentent les mêmes adresses, et le microcontrôleur 4 valide les mémoires tampons 35 d'adresse, et 41 de données, alors que le microcontrôleur 6 valide les mémoires tampons 36 d'adresse, et 42 de données, par des connexions 76 à 79 respectivement. Dans ce cas les microcontrôleurs 4 et 6 interprètent dans ce but les signaux délivrés par les portes OU 11 et 12. Les bits d'adresse AD1 mémorisés dans les mémoires tampons 35 sont appliqués au décodeur 7. Ils permettent de sélectionner une ou des lignes de mot de la mémoire 2.

De la même manière les données D1 sont présentes à la sortie du démultiplexeur de données 38 et à l'entrée de la mémoire tampon 41. La pompe de charge 32 est activée en même temps que les mémoires tampons. Elle permet de polariser les lignes de bit de la mémoire à des tensions de programmation. Dans ces conditions, sur la base des adresses AD1 disponibles dans la mémoire tampon 35 et des données D1 disponibles dans la mémoire tampon 41, le microprocesseur 4 (qui continue à être validé par l'ordre de durée T) provoque la programmation désirée dans la mémoire 2.

Une fois que la sélection SS1 a permis de déclencher ces actions, le signal SS1 peut retomber, après ou avant le transfert des données ou des adresses dans les mémoires tampons 41 et 35, selon le mode normal ou selon le mode en variante retenu. Dans le mode normal, les transferts d'adresses et de données peuvent même être antérieurs à l'ordre SS1 si la commande des démultiplexeurs 34 et 38 est externe.

Au moment du front descendant 74 du signal de sélection SS1, le signal SS2 devient actif. Il autorise une sélection de la mémoire 3. Le signal de sélection SS2 déclenche, si le signal d'écriture est resté actif, un signal SME2 de temporisation de durée T' issu du circuit 14. La durée produite par le circuit 14 n'est pas nécessairement la même que la durée T du circuit 13. Elle dépend de la vitesse de programmation de la mémoire 3 comparée à celle de la mémoire 2. Un signal de maintien est produit en conséquence à la sortie du circuit logique 12 pour valider le microcontrôleur 6. Le microcontrôleur 6 devient alors autonome à son tour et peut exécuter l'opération d'écriture dans la mémoire 3.

Les opérations d'écriture sont simultanées dans les deux mémoires si le front 74 se produit avant la fin de la durée T. La figure 2 montre, vers le bas, les transferts d'adresse AD2 et de données D2 utiles à la programmation de la mémoire 3.

Dès le moment où le signal de temporisation est déclenché, le microcontrôleur fonctionne et effectue les opérations d'écriture indépendamment de la valeur du signal de sélection. On tire donc parti de cette durée d'autonomie pour déclencher l'écriture dans l'autre mémoire.

L'invention trouve tout particulièrement une application dans les tests de fonctionnement pour lequel la durée du temps de test est un facteur de productivité. Les opérations d'écriture et de lecture pouvant être effectuées dans deux mémoire distinctes du même circuit intégré, ceci réduit le temps des tests et a fortiori le coût du test.

Tout ce qui vient d'être dit pour l'écriture est valable pour la lecture. Dans la mesure où une opération d'écriture dure de l'ordre de 500 microsecondes, on voit l'intérêt qu'il y a à en exécuter deux en même temps. Pour la lecture, il convient, sur un cycle de lecture de quelques microsecondes, de retenir qu'une lecture de cellules proprement dite dure environ 100 nanosecondes. Avec le procédé de l'invention, on commence la lecture dans une mémoire. Pendant qu'elle se poursuit, on commence la lecture dans l'autre. Puis on peut resélectionner (en se synchronisant) le bus 46 de la première mémoire (puis le bus 47) avec les éléments multiplexeur 50 pour assurer le transfert des données lues sur le bus 71.

Dans le cas de la lecture, bien entendu, il est seulement nécessaire que les durées T" et T"' des signaux SML1 et SML2 délivrés par les circuits 25 et 26 (qui peuvent être égales entre elles) soit supérieures ou égales aux durées de lecture. Elles peuvent être aussi supérieures ou égales aux durées d'écriture bien que cela soit peu utile.

## Revendications

1. Circuit intégré (1) comportant deux mémoires (2,3) distinctes l'une de l'autre, un microcontrôleur (4) pour séquencer des opérations d'écriture ou de lecture de ces mémoires (2,3), un circuit de sélection (5) propre à sélectionner l'une ou l'autre des mémoires (2,3) et recevant un signal de sélection (SS1,SS2), **caractérisé en ce que**:
- ce circuit intégré (1) comporte deux microcontrôleurs (4,6) en relation chacun avec une des mémoires (2,3), et **en ce que**
- chaque microcontrôleur (4,6) comporte un circuit (13,14) pour exécuter dans chaque mémoire (2,3) les opérations d'écriture ou de lecture indépendamment de la valeur du signal de sélection (SS1,SS2).

2. Circuit selon la revendication 1 **caractérisé en ce que** chaque microcontrôleur (4,6) est relié au circuit de sélection (5) par l'intermédiaire de moyens (13,14) propres à fournir un signal de temporisation de durée donnée (T), déclenché lors d'une sélection, pour produire un signal maintenu (SME1,SME2) pendant cette durée donnée, la durée donnée étant supérieure ou égale à une durée d'exécution d'une lecture ou d'une écriture.

3. Circuit selon l'une des revendications 1 à 2 **caractérisé en ce qu'**il comporte
- un circuit (18) pour que les signaux de sélection soient complémentaires afin de ne sélectionner qu'une seule mémoire (2,3) à la fois.

4. Circuit selon l'une des revendications 1 à 3 **caractérisé en ce que**
- le circuit (5) de sélection comporte au moins un premier circuit logique (21) qui reçoit une commande d'écriture (E) commune aux deux mémoires et qui reçoit le signal de sélection (SS1,SS2), le circuit logique (21) permettant de sélectionner (SME1,SME2) une de ces deux mémoires (2,3) en écriture.

5. Circuit selon l'une des revendications 1 à 4, **caractérisé en ce que**
- le circuit (5) de sélection comporte un deuxième circuit logique (24) qui reçoit une commande de lecture (L) commune aux deux mémoires (2,3) et qui reçoit le signal de sélection (SS1,SS2), le circuit logique (24) permettant de sélectionner (SME1,SME2) une de ces deux mémoires (2,3) en lecture.

6. Circuit selon l'une des revendications 4 ou 5 **caractérisé en ce que** le circuit logique (24) comporte deux portes (27 et 28) à deux entrées, une première entrée de ces portes recevant le signal de sélection (SS2, SS1), une deuxième entrée recevant le signal d'écriture ou de lecture, pour permettre la sélection d'une mémoire exclusivement en écriture ou en lecture.

7. Circuit selon l'une des revendications 1 à 6, **caractérisé en ce qu'**il comporte
- des décodeurs (7,8,29,31) d'adresses dupliqués pour permettre le décodage d'adresses dans chacune des mémoires (2,3) indépendamment l'une de l'autre.

8. Circuit selon l'une des revendications 1 à 7, **caractérisé en ce qu'**il comporte
- des pompes de charge (32,33) dupliquées pour polariser des lignes dans chacune des mémoires (2,3) indépendamment l'une de l'autre.

9. Circuit selon l'une des revendications 1 à 8, **caractérisé en ce qu'**il comporte
- une porte OU en entrée de validation de chaque microcontrôleur (11,12) pour recevoir les signaux maintenus de lecture et d'écriture, et pour produire un signal de maintien pendant l'opération d'écriture ou lecture.

10. Circuit selon la revendication 5, **caractérisé en ce qu'**il comporte
- un multiplexeur (50) de sortie, commandé par des signaux de lecture issus (73) du deuxième circuit logique (24) et qui fournit en sortie les données lues dans la mémoire (2,3) sélectionnée.

11. Circuit selon la revendication 5, **caractérisé en ce qu'**il comporte
- un multiplexeur (50) de sortie commandé (55) par les signaux de maintien (SML1) propres à fournir en sortie la donnée lue issue de la mémoire sélectionnée.

## Patentansprüche

1. Integrierter Schaltkreis (1) mit zwei zueinander unterschiedlichen Speichern (2, 3), einem Mikrocontroller (4) zum Steuern von Schreib- oder Leseoperationen dieser Speicher (2, 3), einem Auswahlschaltkreis (5) zum Auswählen des einen oder des anderen Speichers (2, 3) und zum Empfangen eines Auswahlsignals (SS1, SS2), **dadurch gekennzeichnet,daß**
der integrierte Schaltkreis (1) zwei Mikrocontroller (4, 6) aufweist, die jeweils mit einem der Speicher (2, 3) verknüpft sind, und daß
jeder Mikrocontroller (4, 5) einen Schaltkreis (13, 14) zum Ausführen der Schreib- oder Leseoperationen in jedem Speicher (2, 3) unabhängig von dem Wert des Auswahlsignals (SS1, SS2) aufweist.

2. Schaltkreis nach Anspruch 1, **dadurch gekennzeichnet,daß** jeder Mikrocontroller (4, 6) mit dem Auswahlschaltkreis (5) über Mittel (13, 14) zum Liefern eines temporären Signals gegebener Dauer (T), das bei einer Auswahl ausgelöst wird, verbunden ist, um ein Haltesignal (SME1, SME2) während dieser gegebenen Dauer zu erzeugen, wobei die gegebene Dauer größer oder gleich einer Ausführungsdauer eines Lese- oder eines Schreibvorgangs ist.

3. Schaltkreis nach einem der Ansprüche 1 bis 2, **dadurch gekennzeichnet, daß** er ein Schaltkreis (18) aufweist, für den die Auswahlsignale komplementär sind, um nur einen Speicher (2, 3) auf einmal auszuwählen.

4. Schaltkreis nach einem der Ansprüche 1 bis 3, **dadurch gekennzeichnet,daß** der Auswahlschaltkreis (5) wenigstens einen ersten Logikschaltkreis (21) aufweist, der einen für beide Speicher gemeinsamen Schreibbefehl (E) und das Auswahlsignal (SS1, SS2) empfängt, wobei der Logikschaltkreis (21) das Auswählen (SME1, SME2) einer der zwei Speicher (2, 3) zum Schreiben erlaubt.

5. Schaltkreis nach einem der Ansprüche 1 bis 4, **dadurch gekennzeichnet,daß** der Auswahlschaltkreis (5) einen zweiten Logikschaltkreis (24) aufweist, der einen für beide Speicher (2, 3) gemeinsamen Lesebefehl (L) und das Auswahlsignal (SS1, SS2) empfängt, wobei der Logikschaltkreis (24) das Auswählen (SME1, SME2) einer der beiden Speicher (2, 3) zum Lesen erlaubt.

6. Schaltkreis nach einem der Ansprüche 4 oder 5, **dadurch gekennzeichnet,daß** der Logikschaltkreis (24) zwei Gatter (27 und 28) mit zwei Eingängen aufweist, wobei ein erster Eingang dieser Gatter das Auswahlsignal (SS1, SS2) empfängt und ein zweiter Eingang das Schreib- oder Lesesignal empfängt, um die Auswahl eines Speichers ausschließlich für das Schreiben oder für das Lesen zu ermöglichen.

7. Schaltkreis nach einem der Ansprüche 1 bis 6, **dadurch gekennzeichnet,daß** er zwei Adreßdecoder (7, 8, 29, 31) aufweist, um die Decodierung von Adressen in jedem der Speicher (2, 3) unabhängig voneinander zu ermöglichen.

8. Schaltkreis nach einem der Ansprüche 1 bis 7, **dadurch gekennzeichnet,daß** er zwei Ladungspumpen (32, 33) aufweist, um die Leitungen in jedem Speicher (2, 3) unabhängig voneinander vorzuspannen.

9. Schaltkreis nach einem der Ansprüche 1 bis 8, **dadurch gekennzeichnet,daß** er ein ODER-Gatter am Freigabeeingang jedes Mikrocontrollers (11, 12) zum Empfangen der Haltesignale zum Lesen und zum Schreiben und zum Erzeugen eines Haltesignals während des Schreibvorgangs oder des Lesevorgangs aufweist.

10. Schaltkreis nach Anspruch 5, **dadurch gekennzeichnet,daß** er einen Ausgangsmultiplexer (50) aufweist, der von Lesesignalen (73) gesteuert wird, die von dem zweiten Logikschaltkreis (24) ausgegeben werden, und der an seinem Ausgang die aus dem ausgewählten Speicher (2, 3) gelesenen Daten liefert.

11. Schaltkreis nach Anspruch 5, **dadurch gekennzeichnet,daß** er einen Ausgangsmultiplexer (50) aufweist, der von den Haltesignalen (SML1) gesteuert wird, um am Ausgang die gelesenen Daten zu liefern, welche aus dem ausgewählten Speicher ausgegeben werden.

## Claims

1. Integrated circuit (1) comprising two memories (2, 3) separate from one another, a microcontroller (4) for sequencing writing or reading operations for these memories (2, 3), a selection circuit (5) suitable for selecting one or other of the memories (2, 3) and receiving a selection signal (SS1, SS2), **characterised in that**
- this integrated circuit (1) comprises two microcontrollers (4, 6) each in relation with one of the memories (2, 3), and **in that**
- each microcontroller (4, 6) comprises a circuit (13, 14) for executing the writing or reading operations in each memory (2, 3) independently of the value of the selection signal (SS1, SS2).

2. Circuit according to claim 1, **characterised in that** each microcontroller (4, 6) is connected to the selection circuit (5) through the intermediary of means (13, 14) suitable for supplying a delay signal of a given time (T), triggered when a selection is made, to produce a holding signal (SME1, SME2) during this given time, the given time being greater than or equal to a time for execution of a reading or a writing operation.

3. Circuit according to one of claims 1 to 2, **characterised in that** it comprises
- a circuit (18) so that the selection signals are complementary in order to select just one memory (2, 3) at a time.

4. Circuit according to one of claims 1 to 3, **characterised in that**
- the selection circuit (5) comprises at least a first logic circuit (21) which receives a writing command (E) common to the two memories and which receives the selection signal (SS1, SS2), the logic circuit (21) permitting the selection (SME1, SME2) of one of these two memories (2, 3) for writing.

5. Circuit according to one of claims 1 to 4, **characterised in that**
- the selection circuit (5) comprises a second logic circuit (24) which receives a reading command (L) common to the two memories (2, 3) and which receives the selection signal (SS1, SS2), the logic circuit (24) permitting the selection (SME1, SME2) of one of these two memories (2, 3) for reading.

6. Circuit according to one of claims 4 or 5, **characterised in that** the logic circuit (24) comprises two gates (27 and 28) with two inputs, a first input of these gates receiving the selection signal (SS2, SS1), a second input receiving the writing or reading signal, to permit selection of a memory exclusively for writing or for reading.

7. Circuit according to one of claims 1 to 6, **characterised in that** it comprises
- duplicated address decoders (7, 8, 29, 31) to permit decoding of addresses in each of the memories (2, 3) independently of one another.

8. Circuit according to one of claims 1 to 7, **characterised in that** it comprises
- duplicated charging pumps (32, 33) to polarise lines in each of the memories (2, 3) independently of one another.

9. Circuit according to one of claims 1 to 8, **characterised in that** it comprises
- an OR gate at the validation input of each microcontroller (11, 12) to receive the reading and writing holding signals and to produce a holding signal during the writing or reading operation.

10. Circuit according to claim 5, **characterised in that** it comprises
- an output multiplexer (50) controlled by reading signals (73) from the second logic circuit (24) and which supplies the data read from the selected memory (2, 3) at the output.

11. Circuit according to claim 5, **characterised in that** it comprises
- an output multiplexer (50) controlled (55) by the holding signals (SML1) suitable for supplying the data read from the selected memory at the output.
